# EUROPEAN PATENT APPLICATION

(11) **EP 1 067 436 A1**
(43) Date of publication of application: **10.01.2001**
(21) Application number: 00114094.6
(22) Date of filing: 07.07.2000
(51) Int. Cl.: G03F 7/029, G03F 1/00

(54) **Image forming composition, image recording material comprising the same, and process of image formation**

(30) Priority: 08.07.1999 JP 19501799
(71) Applicant: TOKYO OHKA KOGYO CO., LTD., Kawasaki-shi Kanagawa, 211 (JP)
(72) Inventor: Fujimoto, Takashi, Yokosuka-shi, Kanagawa (JP); Takagi, Toshiya, Fujisawa-shi, Kanagawa (JP); Seki, Norio, Sagamihara-shi, Kanagawa (JP)
(74) Representative: Albrecht, Thomas, Dr.

(57) **Abstract**

Disclosed is an image forming composition comprising (A) a film-forming resin and (B) an infrared laser beam absorbing substance, an image recording material comprising the same, and a process of image formation using the image recording material.

## Description

### BACKGROUND OF THE INVENTION

### 1. FIELD OF THE INVENTION

This invention relates to an image forming composition which can form an image directly by scanning with an infrared laser beam, an image recording material comprising the composition, and a process of image formation using the image recording material. More particularly, it relates to an image forming composition which forms an image on scanning with an infrared laser beam, an image recording material comprising the composition, such as a lithographic printing plate precursor, a gravure printing plate precursor, a printed wiring board precursor, a liquid crystal display panel precursor, and the like, and a process of image formation using such an image recording material.

### 2. DESCRIPTION OF THE RELATED ART

With the recent advancement of laser scanning exposure techniques, a laser scanning direct imaging system in which CD output data are directly recorded by imagewise exposure with a laser beam has been developed to enable direct platemaking with a laser. According to the laser scanning direct imaging system, since no photographic tools is used, a fine image can be depicted quickly, and a development step can be omitted. However, because the conventional laser scanning imaging system uses a high energy laser beam of an excimer laser, etc., the photopolymerization initiator and the binder resin used in the photosensitive composition must be specific, which increases the production cost of the photosensitive composition. Further, photopolymerization initiators or binder resins that are currently available do not sufficiently respond to high energy laser beams, which has made it difficult to produce satisfactory recording materials.

In order to solve this problem, a laser scanning direct imaging system using an infrared, laser beam has been proposed as disclosed, e.g., in JP-A-8-305030 and JP-A-9-166875. According to the proposals, a photomask is formed by the laser scanning direct imaging system, and a photopolymerizable composition layer is selectively irradiated with ultraviolet light, etc. through the photomask and then developed. Since the laser beam used is a low energy infrared laser beam having a wavelength of 750 to 20,000 nm, the photosensitive composition need not contain an expensive photopolymerization initiator. Besides the economical advantage, an infrared laser beam, which has a longer wavelength than visible light, allows the operation to be carried out under a white lamp. Further, an image of high resolution can easily be formed by controlling the laser beam irradiation conditions. These advantages being taken into consideration, the present inventors have continued their study, expecting that a recorded material having a high resolving power could be obtained at a low cost by improving the above-described image formation process. As a result, they have found that a composition comprising a film-forming resin and an infrared laser beam absorbing substance provides an image-recorded material having a high resolving power economically and rapidly without involving development processing. The present invention has been completed based on this finding.

### SUMMARY OF THE INVENTION

An object of the present invention is to provide an image forming composition which is highly sensitive to an infrared laser beam to produce an image-recorded material rapidly without development.

Another object of the invention is to provide an image recording material comprising the image forming composition.

Still another object of the invention is to provide a process of image formation using the image recording material.

The above objects of the invention are accomplished by an image forming composition comprising (A) a film-forming resin and (B) an infrared laser beam absorbing substance, an image recording material comprising the same, and a process of image formation using the image recording material.

### DETAILED DESCRIPTION OF THE INVENTION

The image forming composition of the invention comprises (A) a film-forming resin and (B) an infrared laser beam absorbing substance. The film-forming resin as component (A) includes a phenolic resin, a urethane resin, an acrylic resin, an epoxy resin, a polyester resin, a melamine resin, a carbonate resin, a styreue resin, a fluororesin, a cellulosic resin, a polysaccharide, a vinyl polymer, a protein, rosin, and a diene polymer. These polymeric materials can be used either individually or as a mixture of two or more thereof. Where the image forming composition is to be removed after image formation, it is desirable for component (A) to be soluble or dispersible in an alkali or swellable with an alkali, more preferably to be soluble in an alkali.

The infrared laser beam absorbing substance as component (B) is not particularly limited as long as it intensely absorbs an infrared laser beam having a wavelength of 700 to 20,000 nm and transmits the energy to the surroundings. The infrared laser beam absorbing substance that "intensely" absorbs an infrared laser beam having a wavelength of 700 to 20,000 nm preferably has an absorption coefficient (ε) of 1 x 10⁴ or more. Substances useful as component (B) include inorganic pigments, such as carbon black, resin-coated carbon black, graphite, copper chromite, and chromium oxide; metals, such as aluminum, copper, and zinc; alloys of bismuth, indium or copper; arid dyes, such as polyphthalocyanine dyes, cyanine dyes, squazylium dyes, chalcogenopyryloarylidene dyes, bis(chalcogenopyzylo)polymethylene dyes, oxyindolizine dyes, bis(aminoaryl)polymethine dyes, merocyanine dyes, croconium dyes, metal thiolate dyes, and quinoid dyes. Carbon black and resin-coated carbon black are particularly preferred for their high ability to absorb an infrared laser beam. The carbon black may be any of furnace black, lamp black, and channel black. The resin-coated carbon black includes carbon black of the above species coated with polyamide, polyester, a urethane resin, etc., such as CF Black RT (trade name) and EX-1455-90 (trade name), both available from Mikuni Shikiso K.K. It is preferred for the infrared laser beam absorbing substance to have a particle size of from 0.01 to 10 µm. Particles smaller than 0.01 µm tend to deteriorate the stability of the image forming composition, and those greater than 10 µm tend to reduce the uniformity of an image forming layer formed of the image forming composition.

The image forming composition of the invention can contain a sensitizer to improve sensitivity to an infrared laser beam. Preferred sensitizers include pyrylium compounds, such as arylbenzo (thio) pyrylium salts, trimethinepyrylium salts, and pentamethine thiopyrylium salts; and diimmonium compounds. The sensitizer may be used in amount of 0 to 30 parts by weight based on 100 parts by weight of the total amount of components (A) and (B). The image forming composition can further contain a plasticizer or a surface active agent to control the film forming properties of the binder resin. Suitable plasticizers include triphenyl phosphite, dimethyl phthalate, diethyl phthalate, dicyolohexyl phthalate, ethylene glycol dibenzoate, glycerol carbonate, polyethylene glycol, and tributyl citrate. Suitable surface active agents include fluorine-containing surface active agents. The image forming composition can furthermore contain a photo- or thermo-polymerizable monomer in conjunction with a photo- or thermo-polymerization initiator to have improved etching resistance. The photo- or thermo-polymerizable monomers include t-butyl acrylate, lauryl acrylate, 1,4-butanediol diacrylate, and hexamethylene glycol diacrylate. The polymerizabel monomer may be used in an amount of 0 to 60% by weight based on 100 parts by weight of the total amount of components (A) and (B). The polymerization initiators include benzoin compounds and benzoic acid derivatives. The polymerization initiator may be used in amount of 0 to 50% by weight based on 100 parts by weight of the total amount of components (A) and (B).

The image forming composition is prepared by compounding the above-described components by means of a known mixing machine, for example a sand mill, a three-roll mill or a pressure kneader. The composition preferably comprises 20 to 95% by weight, particularly 50 to 80% by weight, of component (A), based on the total amount of components (A) and (B) and 15 to 80% by weight, particularly 20 to 50% by weight, of component (B), based on the total amount of components (A) and (B).

The image forming composition is dissolved in a solvent on use. Suitable solvents include ethylene dichloride, cyclohexanone, methyl ethyl ketone, methanol, ethanol, propanol, ethylene glycol, ethylene glycol monomethyl ether, ethylene glycol monoethyl ether, ethylene glycol monobutyl ether, ethylene glycol monomethyl ether acetate, ethylene glycol monoethyl ether acetate, diethylene glycol, diethylene glycol monomethyl ether, diethylene glycol monoethyl ether, diethylene glycol monobutyl ether, dimethyl sulfoxide, N,N-dimethylformamide, N,N-dimethylacetamide, N-methyl-2-pyrrolidone, 1,3-dimethyl-2-imidazolidinone, γ-butyrolactone, and toluene.

The image recording material according to the present invention is obtained by applying the above-described image forming composition to a substrate having dimensional stability. Suitable substrates include paper, plastic laminated paper, a plastic film of polyethylene terephthalate, polyester, polypropylene, polystyrene, polycarbonate, polyvinyl acetate, etc., a copper plate, a copper-clad laminate, an aluminum plate, an alloy plate, and a glass plate. In particular, a copper plate, a copper-clad laminate, and a glass plate are suitable as a substrate of a gravure printing plate, a printed wiring board, and a display panel, respectively.

The image recording material is produced by coating the substrate with the image forming composition by means of a roll coater, a bar coater, a slit coater, a spray coater, a screen printing machine, etc. or sticking a dry film of the image forming composition separately formed on a temporary substrate, e.g., a polyethylene terephthalate film, to the substrate and removing the temporary substrate. The thickness of the image forming layer is decided appropriately according to the use. For example, a preferred thickness for etching is about 2 to 20 µm, and that for plating is about 5 to 100 µm.

The image recording material can have a barrier layer to protect the image forming layer from oxygen in the air. The barrier layer can be formed by applying a homo- or copolymer of nitrocellulose, ethyl cellulose, an acrylate, a methacrylate or styrene, polyvinyl alcohol, and the like.

The process of image formation on the image recording material of the invention is carried out as follows. The image recording material is selectively irradiated with an infrared laser beam having a wavelength of 700 to 20,000 nm to ablate the irradiated area through sublimation or by blowing off. The recording material is then subjected to etching or plating. The remaining non-irradiated area of the image forming layer used as a mask or a resist is then stripped off to give an image-recorded matarial. Since development processing is not necessary after image formation, the production cost can be reduced. Since the infrared laser beam used has a wavelength of 700 to 20,000 nm, the image formation can be performed with ease under a white lamp. Further, a fine image can be formed with high resolution by controlling the irradiation conditions, and a recorded material is produced rapidly.

Lasers used in the invention which emit an infrared laser beam having a wavelength of 700 to 20,000 nm include a semiconductor laser emitting a laser beam having a wavelength of 750 to 880 nm, a YAG laser emitting a laser beam having a wavelength of 1060 nm, and a carbonic acid gas laser. Where a flexible image recording material is used in the production of a lithographic printing plate, a gravure printing plate, a printed wiring board, etc., it is effective to attach the image recording material around a drum and irradiate the cylindrical image recording material with an infrared laser beam. In this embodiment, productivity is further improved to facilitate cost reduction.

Etching can be conducted with an etchant, such as an iron chloride aqueous solution or a copper chloride aqueous solution. The image forming layer can be stripped with a resist stripper, such as a 1 to 10 wt% dilute aqueous solution of an alkali. The alkali includes a hydroxide, a carbonate, a hydrogencarbonate, a phosphate or a pyrophosphate of an alkali metal, such as lithium, sodium or potassium; primary amines, such as benzylamine and butylamine; secondary amines, such as dimethylamine, dibenzylamine and diethanolamine; tertiary amines, such as trimethylamine, triethylamine, and triethanolamine; cyclic amines, such as morpholine, piperazine, and pyridine; polyamines, such as ethylenediamine and hexamethylenediamine; ammonium hydroxides, such as tetraethylammonium hydroxide, trimethylbenzylammonium hydroxide, and trimethylphenylbenzylammonium hydroxide; sulfonium hydroxides, such as trimethylsulfonium hydroxide, diethylmethylsulfonium hydroxide, and dimethylbenzylsulfonium hydroxide; and quaternary ammonium salts, such as trimethylammonium hydroxide.

In case where the image forming layer of the image recording material has insufficient etching resistance, the etching resistance can be improved by incorporating into the image forming composition a photo- or thermo-polymerizable monomer and a photo- or thermo-polymerization initiator which are compatible with the film-forming resin and curing the image forming layer by irradiation with ultraviolet rays or infrared rays, particularly ultraviolet rays, or by heat application.

The present invention will now be illustrated in greater detail with reference to Examples, but it should be understood that the invention is not construed as being limited thereto.

### EXAMPLE 1

Hydroxypropyl methylcellulose phthalate HP-50 (available from Shin-Etsu Chemical Co., Ltd.; acid value; 84) (35 g), 51.5 g of a polyurethane binder SSU-12BC (a reaction product between hexamethylene diisocyanate and a polydiol (polyester:polyol=1:1), available from Kyoeisha Kagaku), 35 g of resin-coated carbon black CF Black RT (available from Mikuni Shikiso K.K.), and 3.5 g of a diimmonium sensitizer were mixed up in a roll mill, and 634.5 g of cyclohexanone was added thereto to prepare an image forming composition. The resulting composition was applied to a 20 µm thick polyester film as a temporary substrate with a bar coater and dried at 80°C for 5 minutes. The coating film was covered with a 25 µm thick polyethylene film to prepare a dry resist film.

The polyethylene film was removed, and the image forming layer of the dry resist film was stuck to a flexible wiring substrate attached to a rotating drum. The polyester film was stripped off to prepare an image recording material having an image forming layer having a thickness of 4.5 µm. The absorbance of the image recording material was 2.1 Abs (λ=1060 nm) and 2.3 Abs (λₘₐₓ=950 nm).

The image recording material on the drum was selectively irradiated with a YAG laser beam (output; 12 W; cylinder diameter: 326.6 mm; number of revolution of cylinder: 500 rpm; beam diameter: 20 µm; Res 50) to cause imagewise ablation of the irradiated area of image forming layer. The image recording material was etched with an etchant comprising an iron chloride aqueous solution, treated with a 1% sodium carbonate aqueous solution to remove the remaining image forming layer, and dried to obtain a printed wiring board having a fine wiring pattern.

### EXAMPLE 2

The image forming composition prepared in Example 1 was applied to a copper-plated cylinder with a roll coater and dried at 80°C for 5 minutes to form a 5 µm thick resist film. The resist film was selectively irradiated with a semiconductor laser beam to cause imagewise ablation of the irradiated area of the resist film. The exposed copper layer was etched with an etchant comprising a cupric chloride aqueous solution, and the remaining image forming layer was stripped off with a 1% sodium carbonate aqueous solution. The etched cylinder was plated with chronium to obtain a gravure printing plate cylinder. When gravure printing was conducted on the plate cylinder, prints of high resolution were produced.

### EXAMPLE 3

An image forming composition was compounded from 70 g of a methacrylic acid/methyl methacrylate/2-hydroxypropyl methacrylate copolymer (acid value: 120; molecular weight: 45,000), 30 g of the resin-coated carbon black used in Example 1, 120 g of ethylene glycol monomethyl ether, and 80 g of cyclohexanone. The composition was applied to a copper-clad laminate (copper layer thickness: 35 µm) with a roll coater and dried at 80°C for 10 minutes to form a photosensitive layer having a thickness of 10 µm. The photosensitive layer was selectively irradiated with a YAG laser beam to ablate the irradiated area. The exposed copper was etched with an etchant comprising cupric chloride. The remaining photosensitive layer was stripped with a 2% aqueous solution of sodium hydroxide at 50°C to give a printed wiring board having a fine wiring pattern.

### EXAMPLE 4

To the image forming composition of Example 3 were added 7 g of trimethylolpropane trimethacrylate, 15 g of tetraethylene glycol diacrylate, 3 g of benzophenone, and 0.3 g of benzotriazole. The resulting composition was applied to a copper-clad laminate to form a photosensitive layer having a dry thickness of 30 µm. The photosensitive layer was selectively irradiated with a YAG laser beam to ablate the irradiated area. The entire area of the residual photosensitive layer was irradiated with ultraviolet light having a wavelength of 300 to 400 nm to cure. The laminate was plated with copper in a copper sulfate plating bath to a deposit thickness of 20 µm. The photosensitive layer was stripped with a 3% aqueous solution of sodium hydroxide at 50°C, and the exposed copper was etched with an etchant comprising cupric chloride to give a printed wiring board having a fine wiring pattern.

The image forming composition of the invention is ablated on irradiation with an infrared laser beam having a wavelength of 700 to 20,000 nm with high sensitivity to form a high precision image. A recorded material of high resolution can be produced by selectively irradiating an image recording material comprising the image forming composition with an infrared laser beam to remove the irradiated area by ablation, followed by etching or plating, and finally removing the remaining image forming composition. Involving no development processing, the recorded material is produced at a reduced cost with high productivity.

The entire disclosure of each and every foreign patent application from which the benefit of foreign priority has been claimed in the present application is incorporated herein by reference, as if fully set forth.

## Claims

1. An image forming composition comprising (A) a film-forming resin and (B) an infrared laser beam absorbing substance.

2. An image forming composition according to claim 1, wherein said film-forming resin is selected from the group consisting of a phenolic resin, a urethane resin, an acrylic resin, an epoxy resin, a polyester resin, a melamine resin, a carbonate resin, a styrene resin, a fluororesin, a cellulosic resin, a polysaccharide, a vinyl polymer, a protein, rosin, and a diene polymer.

3. An image forming composition according to claim 1, wherein said film-forming resin is capable of dissolving or dispersing in an alkali or swelling with an alkali.

4. An image forming composition according to claim 1, wherein said infrared laser beam absorbing substance is a substance which intensely absorbs an infrared laser beam having a wavelength of 700 to 20,000 nm.

5. An image forming composition according to claim 4, wherein said substance comprises at least one of carbon black and resin-coated carbon black.

6. An image forming composition according to claim 1, which comprises 20 to 95% by weight of component (A) and 5 to 80% by weight of component (B) based on the total amount of components (A) and (B).

7. An image forming composition according to claim 6, which comprises 50 to 80% by weight of component (A) and 20 to 50% by weight of component (B) based on the total amount of components (A) and (B).

8. An image forming composition according to claim 1, which further comprises (C) a polymerizable monomer and (D) a polymerization initiator.

9. A patter forming composition according to claim 1, which further comprises (E) a sensitizer.

10. An image forming composition according to claim 9, wherein said sensitizer is at least one of a pyrylium compound and a diimmonium compound.

11. An image recording material comprising a dimensionally stable substrate and an image forming layer, wherein the image forming layer comprises an image forming composition comprising (A) a film-forming resin and (B) an infrared laser beam absorbing substance.

12. A process of image formation comprising selectively irradiating the image recording material according to claim 11 with an infrared laser beam to ablate the irradiated area of said image forming layer, etching the exposed substrate, and stripping the non-irradiated area of said image forming layer.

13. The process of image formation according to claim 11, wherein said image forming layer from which the irradiated area has been removed is cured by ultraviolet irradiation or heat application, prior to said etching.

14. A process of image formation comprising selectively irradiating the image recording material according to claim 11 with an infrared laser beam to remove the irradiated area of the image forming layer, plating the exposed substrate, and stripping the non-irradiated area of said image forming layer.

15. The process of image formation according to claim 14, wherein said image forming layer from which the irradiated area has been removed is cured by ultraviolet irradiation or heat application, prior to said plating.
